# EUROPÄISCHE PATENTANMELDUNG

(11) **EP 0 841 841 A2**
(43) Veröffentlichungstag der Anmeldung: **13.05.1998**
(21) Anmeldenummer: 97119677.9
(22) Anmeldetag: 11.11.1997
(51) Int. Cl.: H05K 7/14, H05K 7/18

(54) **Gehäuse für elektrische Komponenten und Baugruppen**

(30) Priorität: 11.11.1996 DE 19646481
(71) Anmelder: AEG Intermas GmbH, 64546 Mörfelden-Walldorf (DE)
(72) Erfinder: Diedrich, Frank, 63322 Rödermark (DE); Bohnenberger, Willi, 63533 Mainhausen (DE); Haxel, Gerd, 63500 Seligenstadt (DE)
(74) Vertreter: Stoffregen, Hans-Herbert, Dr. Dipl.-Phys.

(57) **Zusammenfassung**

Die Erfindung bezieht sich auf ein Gehäuse aus Metall oder metallisiertem Werkstoff für elektrische Baugruppen und Komponenten mit Gehäusekanten (6, 6 a) und Gehäuseecken (2, 3, 4, 5) umfassenden Rahmen und von diesen aufnehmbaren Seitenwänden (9) sowie oberen und unteren Wänden (10). Um kostengünstig und aus bevorrateten Elementen Gehäuse gewünschter Größe herstellen zu kennen, wird vorgeschlagen, dass die Gehäusekanten metallische Profilträger und die Gehäuseecken metallische Eckkörper sind, dass jeder Eckkörper mit drei Profilträgern verschraubt ist, die sich in drei jeweils rechtwinklig zueinander ausgerichteten Richtungen erstrecken, dass die Seitenwände (9) durch in Nuten zumindest der vorderen und rückwärtigen Profilträger (7, 7 a,) eingespannte Platten gebildet sind und dass die oberen und unteren Wände als mit ihren Rändern in Nuten der vorderen und rückwärtigen Profilträger und Absätze der seitlichen Profilträger eingesetzte metallische Platten ausgebildet sind.

## Beschreibung

Die Erfindung bezieht sich auf ein Gehäuse aus Metall oder metallisiertem Material für elektrische Komponenten und Baugruppen mit Gehäusekanten und Gehäuseecken umfassende Rahmen und von diesen aufnehmbare Seitenwände sowie obere und untere Wände.

Die Leistungsfähigkeit von Datenverarbeitungseinrichtungen hängt in besonderem Maße von den Taktfrequenzen ab, mit denen die logischen Bausteine betrieben werden. Hohe Taktfrequenzen können elektromagnetische Schwingungen hervorrufen, die sich im Raum ausbreiten und andere Geräte stören. Um die Ausbreitung solcher Schwingungen zu verhindern, werden die elektronischen Komponenten, Schaltungen und Baugruppen in Metallgehäusen angeordnet, die einerseits das Austreten strörender elektromagnetischer Schwingungen aus den Gehäusen und andererseits das Eindringen störender elektromagnetischer Schwingungen in die Gehäuse weitgehend bzw. bis zu hohen Frequenzen unterbinden.

Der Raumbedarf elektronischer Geräte, z. B. der Steuer-, Mess-, Regel- und Datenverarbeitungstechnik ist unterschiedlich hoch.

Auch die Stückzahlen sind für die verschiedenen Geräte unterschiedlich. Gehäuse, die nur für ein bestimmtes Gerät ausgelegt sind, tragen daher insbesondere bei geringen Stückzahlen wesentlich zu den gesamten Kosten des jeweiligen Gerätes bei.

Hier setzt die Erfindung ein. Der Erfindung liegt das Problem zugrunde, ein stabiles Gehäuse insbesondere Metallgehäuse bereitzustellen, das aus einfach ausgebildeten und an gewünschte Gehäusegrößen leicht anpassbaren Teilen besteht und das für die Aufnahme genormter Baugruppenträger in verschiedenen Normgrößen mit entsprechend angepassten Teilen geeignet und wirtschaftlich herstellbar ist. Dabei soll durch Austausch von Einzelelementen eine gewünschte Größe herstellbar sein, wobei für den Fall, dass eine Abschirmung in Bezug auf elektromagnetischer Strahlung gewünscht wird, mit einfachen Maßnahmen eine Abschirmung erfolgen soll.

Das Problem wird erfindungsgemäß im wesentlichen dadurch gelöst, dass die Gehäusekanten metallische Profilträger und die Gehäuseecken metallische Eckkörper sind, dass jeder Eckkörper mit drei Profilträgern verschraubt ist, die sich in drei jeweils rechtwinklig zueinander ausgerichteten Richtungen erstrecken, dass die Seitenwände durch in Nuten zumindest der vorderen und rückwärtigen Profilträger eingespannte Platten gebildet sind und dass die oberen und unteren Wände als mit ihren Rändern in Nuten der vorderen und rückwärtigen Profilträger und Absätze der seitlichen Profilträger eingesetzte metallische Platten ausgebildet sind.

Bei dem erfindungsgemäßen Gehäuse sind die aufwendiger, z.B. mit teuren Werkzeugen herstellbaren Teile, nämlich die Eckkörper, bei allen Gehäusegrößen gleich ausgebildet. Da sie für alle Gehäusegrößen verwendbar sind, ergeben sich höhere Stückzahlen, so dass die Gehäuse insgesamt kostengünstiger herstellbar sind. Die Profilträger werden jeweils auf die gewünschte Gehäusegröße abgeschnitten, was relativ einfach ist. Die Seitenwände werden von Hand in die Nuten eingedrückt, d.h. es sind keine aufwendigen Handgriffe oder Werkzeuge erforderlich. Die eine Wand an den Nuten ist hierbei insbesondere so dünnwandig ausgebildet, dass sie elastisch verbiegbar beim Einstecken der Seitenwände ist und diese nach dem Einstecken durch die Federkraft in ihrer Lage fixiert.

Die Profilträger weisen jeweils ein in Achsrichtung verlaufendes Loch auf, das mit einem Loch in dem formschlüssig an den jeweiligen Profilträger anlegbaren Eckkörper fluchtet und in das eine Schneidschraube einsetzbar ist. Durch diese Ausbildung lassen sich die Profilträger und die Gehäuseecken, die im folgenden auch Eckkörper genannt werden, mittels weniger Handgriffe schnell aneinander befestigen.

Es ist zweckmäßig, wenn für die Frontseite des Gehäuses insbesondere in Form eines Tischgehäuses zwei verschiedene Arten von Profilträgern und Eckkörpern vorgesehen sind. Bei der ersten Art sind die Profilträger zur Frontseite mit nutenlosen, glatten Flächen versehen. Bei dieser Ausführungsform verschließen die Frontplatten der in einem Einschub eingesetzten Baugruppenträger das Gehäuse und grenzen an die glatten Flächen der Baugruppenträger an.

Die vertikalen Profilträger an der Frontseite und die Eckkörper haben jeweils an der Frontseite des Gehäuses eine ebene, vertikale an die Öffnung des Gehäuses angrenzende Fläche, von denen in der Mitte des Gehäuses abgewandtem Rand eine vertikale Fläche rechtwinklig nach der Außenseite des Gehäuses hin vorspringt. Unter vertikaler Fläche ist zu verstehen, dass die Fläche in der Aufstellungsposition, d.h. in der Position, in der das Gehäuse auf einer ebenen Fläche aufgestellt ist, vertikal verläuft. Entsprechend der Aufstellungsposition ist die Angabe horizontal zu verstehen.

Die vorstehend beschriebenen Flächen sind auf die Abmessungen von Türscharnieren abgestimmt, die an den nach außen vorspringenden Flächen befestigbar sind.

Bei der zweiten Art sind die Profilträger und Eckverbinder, die die Öffnung des Tischgehäuses auf der Vorder- und Rückseite rahmenartig umgeben, mit nach der Vorder- und der Rückseite hin offenen schmalen Anschlagflächen für Federn aufweisenden Nuten versehen, in die Federn für die Herstellung elektrisch leitender Verbindungen mit Front- und Abdeckplatten einsetzbar sind. Die Nuten sind zweckmäßigerweise so schmal ausgebildet, dass beim Spritzlackieren des Gehäuses kein Farbnebel eindringt. Dies bedeutet eine wesentliche Vereinfachung des Herstellungsvorgangs des Gehäuses.

Bei einer weiteren zweckmäßigen Ausführungsform weisen die horizontalen Profilträger und die beiderseits mit diesen verbundenen Eckkörper nach oben bzw. unten offene, parallele Nuten auf, von denen die näher an der Gehäusemitte angeordneten Nuten mit Anschlagflachen für die Einfügung von Federn versehen sind, mit den Kontaktfedern unverlierbar in den Nuten gehalten werden, die mit Endabschnitten aus den Nuten herausragen, und wobei in den Profilträgern und Eckkörpern zur Mitte des Gehäuses hin gerichtete Anlageflächen vorgesehen sind. Vorzugsweise sind ebene metallische Abdeckbleche zur Abdeckung der oberen und/oder unteren Seite des Gehäuses an einer vorderen oder rückwärtigen Seite mit einer zweimal um 90 ° abgewinkelten Abkantung und seitlich mit einer einfachen um 90 ° abgewinkelten Abkantung versehen. Derartige Abdeckbleche haben aufgrund der Abkantung eine hohe Stabilität gegen Durchbiegung d.h. sie können als dünnwandige Bleche auch großflächig die obere und/oder untere Gehäuseseite abdecken.

Die Montage dieser Abdeckbleche ist sehr einfach, da sie nur auf drei Seiten in nach oben bzw. unten offene Nuten eingelegt sind und auf der anderen Seite an die Anschlagfläche geschoben werden müssen. Damit befinden sich die Anschlagflächen in Montagestellung und können an den Profilträgern angeschraubt werden.

Besonders günstig ist es, wenn an den Eckkörpern in Richtung parallel zu den Seitenwänden Laschen vorspringen, die in Nuten der die Seitenwände oben und unten begrenzenden Profilträger eingreifen und wenigstens eine Gewindebohrung zum Anschrauben von Anschlagwinkeln für die seitlichen Ränder von Baugruppenträgern aufweisen, wobei die Anschlagwinkel an ihren der Gehäuseaußenseite zugewandten Flächen in Abstand voneinander angeordnete vertikale Nuten aufweisen und wobei ein vertikaler Vorsprung an jeweils an den Innenseiten des Gehäuses zum Einfügen in eine der Nuten vorgesehen ist. Die Nuten fixieren die Anschlagwinkel in der richtigen Position, wodurch die Montage erleichtert wird. Außerdem lassen sich aufgrund der parallelen Nuten mehrere Tiefeneinstellungen der Anschlagwinkel auswählen.

Weitere Einzelheiten, Vorteile und Merkmale der Erfindung ergeben sich nicht nur aus den Ansprüchen, den diesen zu entnehmenden Merkmalen - für sich und/oder in Kombination -, sondern auch aus der nachfolgenden Beschreibung von der Zeichnung zu entnehmenden bevorzugten Ausführungsbeispielen.

Es zeigen:
- Fig. 1: eine erste Ausführungsform eines Gehäuses in perspektivischer Ansicht,
- Fig. 2: eine zweite Ausführungsform eines Gehäuses in perspektivischer Ansicht,
- Fig. 3: das Gehäuse gemäß Fig. 1 in Explosivdarstellung,
- Fig. 4: einen Teil eines Gehäuses im Bereich einer Ecke im Querschnitt,
- Fig. 5: einen Teil eines Gehäuses im Bereich der oberen Seite im Längsschnitt,

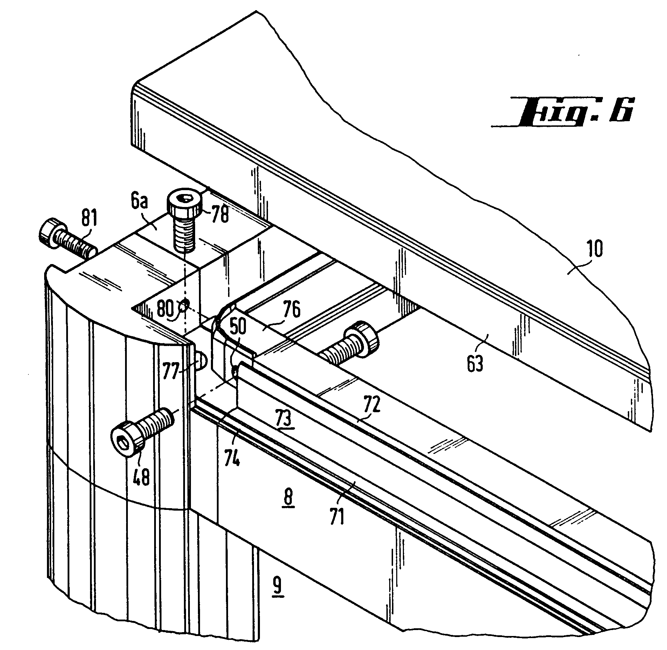

- Fig. 6: einen Teil des Gehäuses im Bereich der unteren Ecke perspektivisch, teilweise in Explosivdarstellung und
- Fig. 7: eine Detaildarstellung eines Abdeckbleches mit Profilträger, im Ausschnitt.

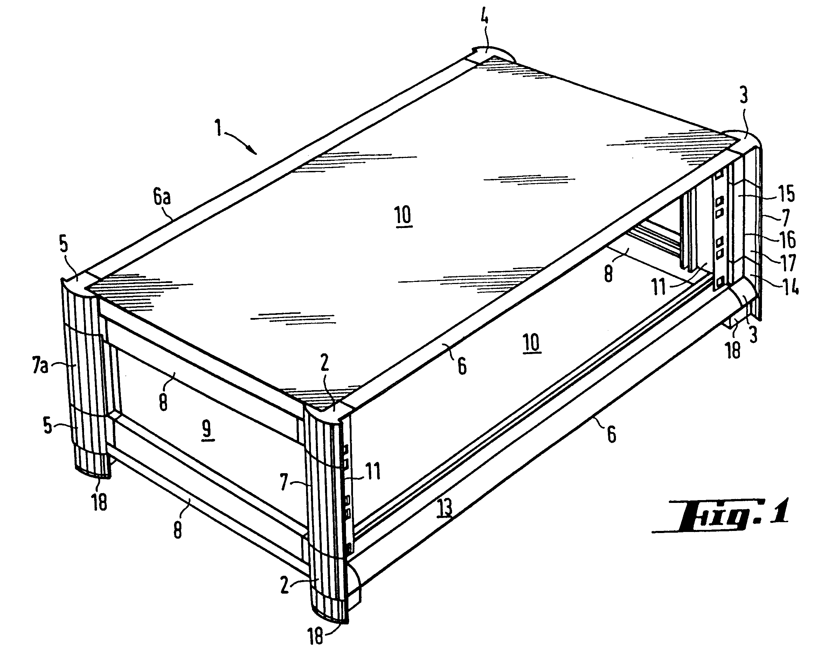

Ein Tischgehäuse 1 einer ersten Ausführungsform weist Rahmen aus gleichen metallischen Eckkörpern auf, von denen in Fig. 1 die oberen Eckkörper 2, 3, 4 und 5 bezeichnet sind. Die entsprechenden unteren sichtbaren Eckkörper weisen wesentliche Bezugszeichen 2, 3 und 5 auf.

Zwischen den Eckkörpern 2, 3, 4, 5 verlaufen vordere metallische Profilträger 6 in Breitenrichtung des Gehäuses, hintere Profilträger 6 a in Breitenrichtung des Gehäuses, vordere bzw. hintere Profilträger 7, 7 a in Höhenrichtung und Profilträger 8 in Tiefenrichtung des Gehäuses 1.

Die Eckkörper 2 bis 5 und Profilträger 6 bis 8 bilden jeweils die Rahmen des Gehäuses 1.

Seitlich am Gehäuse 1 sind gleiche Seitenwände 9 vorgesehen, deren Ränder in Nuten der Rahmen form- und kraftschlüssig eingesetzt sind. Die rückwärtige Gehäuseseite ist mit einer in Fig. 1 nicht dargestellten Abdeckung verschlossen. Die obere und untere Seite des Gehäuses 1 weist gleiche Abdeckungen 10 auf.

In die offene Frontseite des Gehäuses 1 wird ein Baugruppenträger eingesetzt, der nicht dargestellt ist. Zur Halterung des Baugruppenträgers sind beiderseits neben der Öffnung, d.h. an den Eckkörpern 2,3 und den Profilträgern 7, Anschlagwinkel 11 angeschraubt. Die Profilträger 6 haben jeweils eine zur Außenseite des Gehäuses hin konvex gewölbte Fläche, die sich beiderseits den Enden in entsprechenden Flächen der Eckkörper 3 bis hin zu einer vertikalen Fläche 14 der Eckkörper 2, 3 fortsetzt. Die Profilträger 7 weisen jeweils eine horizontale Fläche 15 auf, die in der Ebene der Breitenrichtung des Gehäuses 1 liegt. Die Flächen 15, die sich in entsprechenden, nicht näher bezeichneten Flächen der Eckverbinder fortsetzen, bilden seitliche Begrenzungen der in das Gehäuse 1 einsetzbaren Baugruppenträger.

Von den in bezug auf das Gehäuse 1 äußeren Rändern 16 der Flächen 15 und der an diese angrenzenden, auf der gleichen vertikalen Ebene angeordneten Flächen der Eckkörper 3 gehen ebene Flächen 17 aus, die in der Ebene der Tiefenrichtung des Gehäuses liegen und von den Flächen 15 aus rechtwinklig nach vorne vorspringen.

Die Flächen 17 setzen sich oben und unten in entsprechenden Flächen der Eckkörper 3 fort, die nicht näher bezeichnet sind.

Die rechtwinklig zueinander verlaufenden Flächen 15, 17 mit den nach oben und unten angrenzenden Flächen der Eckkörper 3 sind Anschlagflächen für Scharniere von Türen zur Abdeckung der Frontseite des Gehäuses 1. Die Scharniere können wahlweise links oder rechts angeschlagen werden.

An der Unterseite der unteren Eckkörper 2, 3, 4 und 5 werden Beine 18 befestigt wie angeschraubt, die auf ihrer Vorderseite nicht näher bezeichnete Flächen aufweisen, die je mit den Flächen 15, 17 in einer Ebene liegen.

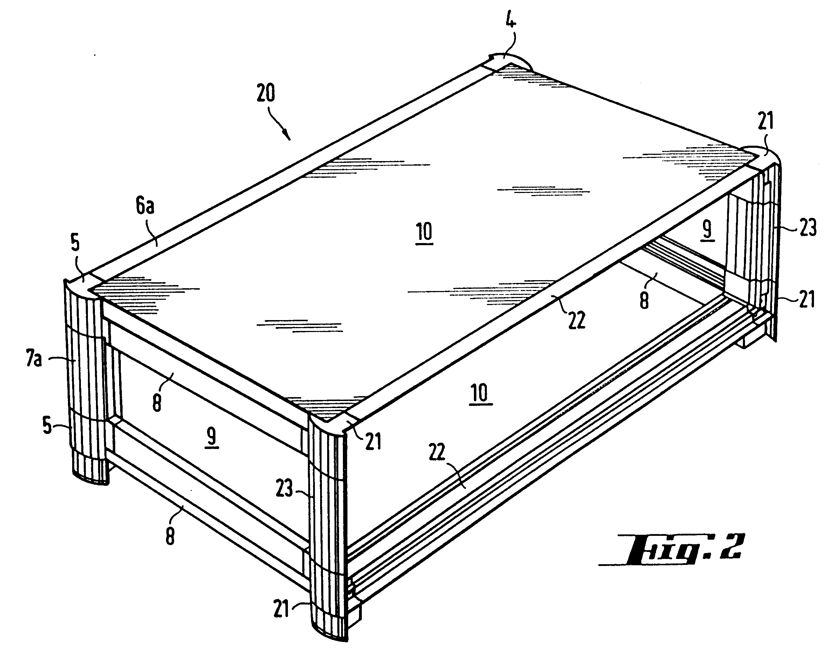

Fig. 2 zeigt ein Gehäuse 20, dessen Aufbau im Prinzip demjenigen des Gehäuses 1 entspricht, d.h. es werden Rahmen aus gleichen vorderen Eckkörpern 21 und zwischen diesen verlaufenden gleichen Profilträgern 22 in Breitenrichtung und gleichen Profilträgern 8 in Tiefenrichtung gebildet.

Zwischen den von den Eckkörpern 4, 5, 21 und den sich zwischen diesen erstreckenden Profilträgern 7 a, 8, 23 gebildeten seitlichen Rahmen sind die Seitenwände 9 und zwischen den oberen und unteren von den Eckkörpern 4, 5, 21 und den zwischen diesen verlaufenden Profilträgern 6 a, 8, 22 gebildeten Rahmen die Abdeckungen 10 in Form der Abdeckplatten angeordnet.

Die Eckkörper 21 und Profilträger 23, 22 des vorderen Rahmens unterscheiden sich von den Eckkörpern 2, 3 und den Profilträgern 7 durch Profile mit Nuten, in die Federn einlegbar sind.

Die rückwärtige Seite des Gehäuses 20 hat den gleichen Aufbau wie das Gehäuse 1, d.h. es sind Eckkörper 4, 5 und vertikale Profilträger 7 a sowie horizontale Profilträger 6 a vorhanden.

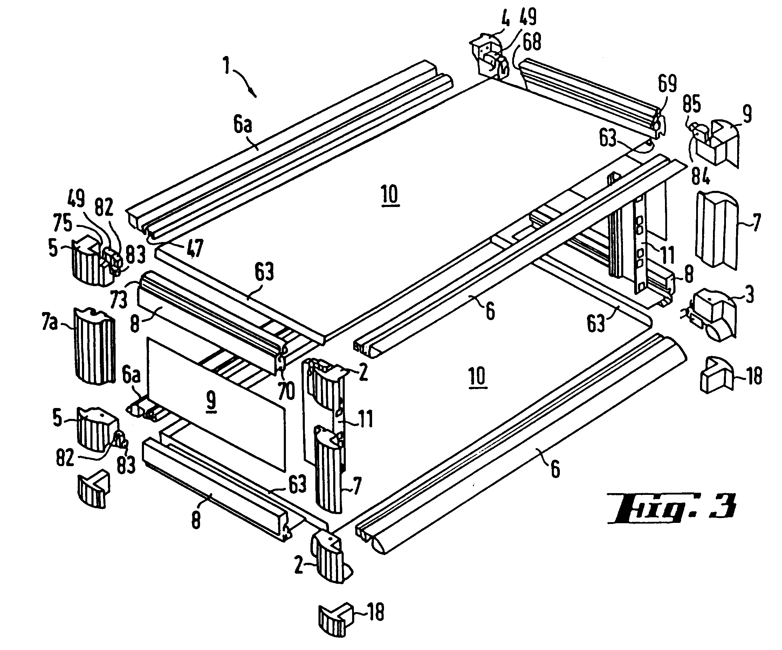

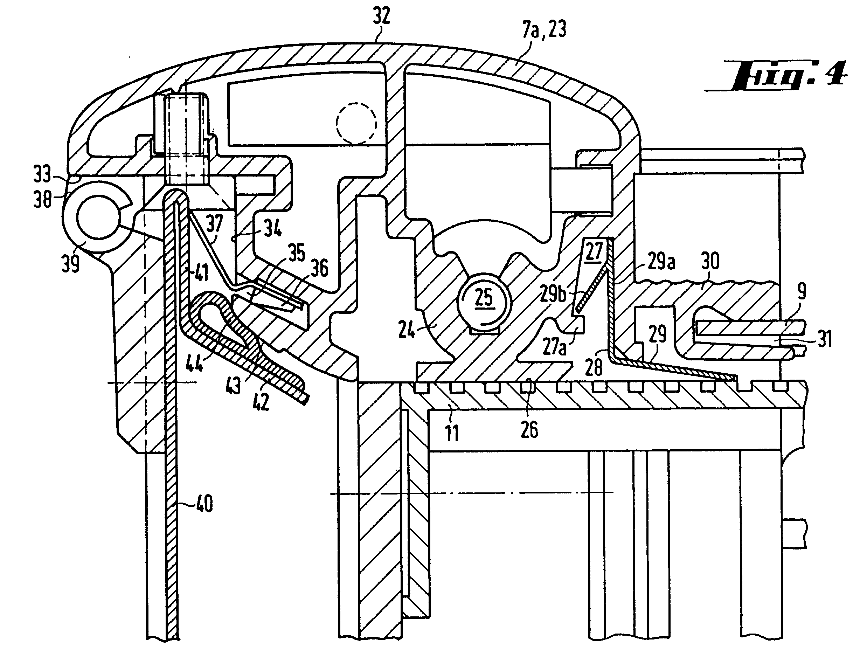

Fig. 3 zeigt das Gehäuse 1 in Explosivdarstellung. Die vertikalen Profilträger 7 a haben den in Fig. 4 näher dargestellten Querschnitt. Bei dem Gehäuse 20 sind die vorderen vertikalen Profilträger 23 und die hinteren vertikalen Profilträger 7 a im Aufbau identisch. Die Profilträger 23 und 7 a haben einen Abschnitt 24 mit einer Durchbrechung wie Loch 25, in das eine Schneidschraube von einem der Eckkörper 2, 3, 4, 5 aus eingeschraubt wird, um die Profilträger 7 a, 23 mit jeweiligen Eckkörpern 4, 5 bzw. 2, 3 zu befestigen. Im Eckkörper 2, 3, 4, 5, 21 ist für die Schraube ein Loch vorgesehen, das in Fig. 3 und 4 nicht dargestellt ist.

Der Abschnitt 24 hat eine breite Anschlagfläche 26 für die Anschlagwinkel 11. Neben der Anschlagfläche 26 ist eine Nut 27 vorgesehen, in die eine Blattfeder 28 eingelegt ist, die mit ihrem in der Nut 27 liegenden Teil gegen die Nutwände und mit einem aus der Nut 27 herausragenden Teil 29 gegen den Winkel 11 gedrückt wird und so eine leitende Verbindung zwischen dem Profilträger 7 a bzw. 23 und dem Winkel 11 herstellt.

Wie sich aus der Fig. 4 ergibt, ist die Blattfeder 28 unverlierbar in der Nut 27 angeordnet. Hierzu weist die Blattfeder 28 einen sich entlang einer Begrenzungswandung der Nut 27 verlaufenden Schenkel 29 auf, von dem ein Abschnitt oder eine Fahne 29 b, die z.B. durch eine Ausstanzung gebildet sein kann, zur gegenüberliegenden Wandung der Nut 27 abragt und mit ihrem äußeren Ende an einem Vorsprung 27 a anlegbar ist, der parallel zum Boden der Nut 27 verläuft. Hierdurch ist sichergestellt, dass die Blattfeder 28 nicht unkontrolliert aus der Nut 27 herausrutschen kann.

Neben der Nut 27 verläuft ein Abschnitt 30 des Profilträgers 7 a bzw. 23, der eine in Längsrichtung der Nut 27 betrachtet senkrecht hierzu verlaufende Nut 31 aufweist, die in Längs- bzw. Tiefenrichtung des Profilträgers 7 a, 23 offen ist. In die Nut 31 ist die Seitenwand 9 mit ihrem Rand eingespannt. Der Profilträger 7 a bzw. 23 hat eine konvex nach außen gewölbte Wand 32 und eine ebene Fläche 33, die in vertikaler Richtung verläuft und der gleichen Fläche am gegenüberliegenden Profilträger des Rahmens zugewandt ist.

Rechtwinklig zur Fläche 33 verläuft eine vertikale ebene Fläche 34, die beim Profilträger 7 a die Rückseite bildet. Beim Profilträger 23 ist die Fläche 34 die Vorderseite. In der Wand mit der Fläche 34 ist eine schmale Nut 35 angeordnet, die unter einem Winkel zur Fläche 35 geneigt ist.

In der Nut 35 wird eine Blattfeder 36 eingelegt, deren eines Ende als Fahne 37 aus der Nut 35 herausragt.

Der Profilträger 23 kann mit einem Beschlag 38 bestückt werden, der ein Scharnier 39 hat. Der Beschlag 38 wird an der Fläche 33 angeschraubt und trägt eine Tür 40, die an ihrem der Fläche 33 zugewandten Rand derart angebördelt ist, dass eine parallel zu der Frontseite verlaufende Zone 41 und eine schräg zur Frontseite verlaufende Randzone 42 vorhanden ist. Gegen die Zone 41 ist bei geschlossener Tür 40 die Fahne 37 angedrückt, wodurch eine Verbindung zwischen der Tür 40, die aus Metall, z.B. Aluminium oder metallisiertem Material besteht und dem Profilträger 23 hergestellt wird.

Die Randzone 42 hat in Schließstellung der Tür 40 einen geringen Abstand zu einer an die Nut 35 angrenzenden Fläche 43 des Profilträgers 23. An der Randzone 42 ist eine Gummidichtung 44 oder elastische Kunststoffdichtung z.B. durch Kleben befestigt. Diese Dichtung wird bei geschlossener Tür 40 gegen die Fläche 43 gedrückt, so dass der Spalt zwischen Tür 40 und Profilträger 23 gut abgedichtet wird.

Die sich über die Breite des Gehäuses 1, 20 erstreckenden Profilträger 6, 6 a haben jeweils einen Abschnitt 46 mit einem einer Ausnehmung wie Loch 47, in das eine Schneidschraube 48 eingesetzt wird, die den jeweiligen Eckkörper 2, 3, 4, 5, 21 mit dem Profilträger 6, 6 a verbindet. Der Eckkörper 4 bzw. 5 bzw. 21 hat einen Vorsprung 49 mit einem Loch 50, in das die Schneidschraube 48 eingesetzt wird. Der Profilträger 6 bzw. 6 a ist an seinen Seiten, die die vordere bzw. rückseitige Gehäuseöffnung umgeben, gleich ausgebildet wie die Profilträger 7 a und 23.

Es sind am Profilträger 6 a ebene Flächen 51, die horizontal verlaufen, und ebene Flächen 52, die rechtwinklig zu den Flächen 51 vertikal verlaufen, vorhanden. In den Flächen 52 befinden sich schräg zu den Flächen 52 verlaufende Nuten 53, in die Blattfedern 54 a eingelegt sind, deren Enden als Fahnen 55 a aus den Nuten 53 herausragen. Die Zone 41 der Tür 40 verläuft entlang aller vier Kanten der Tür 40. Auch die Randzone 42 ist an allen Seiten der Tür 40 vorhanden. Die Dichtung 44 ist längs der gesamten Randzone 42 auf dieser befestigt.

Neben der Nut 53 hat das Profil des Profilträgers 6 bzw. 22 die gleiche Form wie dasjenige der Profilträger 7 a, 23, d.h. es ist eine schräg zur Fläche 52 verlaufende Fläche 43 vorhanden, gegen die die Dichtung 44 bei geschlossener Tür 40 angedrückt wird, so dass die frontseitige Öffnung des Gehäuses 20 vollständig abgedichtet wird.

Die Profilträger 6 a, 22 haben jeweils eine in Abhängigkeit von der oberen und unteren Anordnung im Rahmen oben oder unten verlaufende ebene Fläche 54 auf der Außenseite einer Wand 55, die an einer Kante 56 endet, von der aus eine Wand 57 rechtwinklig zur Wand 55 gegen die Mittelebene des Gehäuses 20 hin verläuft. Die Wand 57 geht in eine Wand 58 auf der dem Inneren des Gehäuses 20 zugewandten Seite der Profilträger 6 a, 22 über. Die Wand 58 erstreckt sich bis zum Abschnitt 46, der in einer gewissen Entfernung von der Wand 57 angeordnet ist und sich auf einem Niveau erstreckt, das nicht ganz die Höhe der Wand 57 erreicht.

Im Raum zwischen der Wand 57 und dem Abschnitt 46 springt eine Leiste 59 von der Wand 58 in Richtung der Außenseite des Gehäuses 20 vor. Das Ende 60 der Leiste 59 ist gegen der Ebene der Fläche 54 zum Inneren in das Gehäuse 20 zurückversetzt. Die Leiste 59 teilt den Raum zwischen der Wand 57 und dem Abschitt 46 in zwei Nuten 61, 62 auf.

Die Abdeckungen 10 haben an den sich in die Tiefe des Gehäuses 1, 20 ersteckenden Seiten um 90 ° abgewinkelte Ränder 63. An der Rück- und Vorderseite sind die Abdeckungen 10 jeweils mit einem Rand 64 versehen, der gegen die obere bzw. untere Seite der Abdeckung 10 um 90 ° abgewinkelt ist. Zusätzlich geht der Rand 64 in eine um 90 ° abgewinkelte Endzone 65 über. Die abgewinkelten Ränder geben der Abdeckung 10 eine große Stabilität, so dass die Abdeckungen 10 dünnwandig ausgebildet sein können.

Der Rand 64 der Abdeckung 10 wird in die Nut 61 eingesetzt, wobei die Endzone 65 an der Wand 58 anliegt. Der Rand 64 ist höher als die Leiste 59. Zwischen dem Ende 60 und der Abdeckung 10 ist eine Dichtung 66 eingespannt. In die Nut 62 ist eine Blattfeder 67 eingelegt, deren Ende über die Nut 62 hinausragt und gegen die Abeckung 10 gedrückt ist, um eine elektrisch leitende Verbindung zwischen der Abdeckung 10 und dem Profilträger 6 a bzw. 22 herzustellen. Die Blattfeder 67 ist dabei unverlierbar in der Nut 62 angeordnet.

Die Blattfedern 36, 28, 54 und 67 sind nicht erforderlich, wenn keine besondere Abschirmung des Inneren des Gehäuses 20 gegen elektromagnetische Störfelder gewünscht wird. Ebenso sind die Dichtungen 44 und 66 nicht notwendig, wenn geringere Anforderungen an den Schutz der Komponenten im Gehäuseinneren erfüllt werden müssen.

Die Profilträger 8 haben jeweils zwei, dem Gehäuseinneren zugewandte Längsnuten 68, 69 eine Längsnut 70, in die jeweils der Rand einer Wand 9 eingesetzt ist, und einen Absatz mit zwei rechtwinklig zueinander verlaufenden Längswänden 71, 72. Der Absatz befindet sich auf der der Gehäuseaußenseite zugewandten Profilseite. Von der Längswand 71 springt eine Leiste 73 parallel zur Längswand 72 vor, hat jedoch nicht die Höhe der Längswand 72.

Die Längswand 71 geht nach der Gehäuseaußenseite in einen weiteren, schmalen Absatz 74 über. Die abgewinkelten Ränder 63 der Abdeckung 10 stützen sich auf den Absätzen 74 der Profilträger 8 ab. In die Nuten zwischen den Seitenwänden 72 und den Leisten 73 können Blattfedern eingelegt sein, deren aus den Nuten herausragende Fahnen an der Abdeckung anliegen und so eine elektrisch leitende Verbindung zwischen den Profilschienen 8 und den Abdeckungen 10 herstellen. Zwischen den Spitzen der Leisten 73 und den Abdeckungen 10 können Dichtungen eingespannt sein.

Die Eckkörper 2, 3, 4, 5 und 21 haben eine nach oben bzw. unten offene Nut 75, die rechtwinklig ihren Verlauf ändert. Auf der einen Seite der Nut 75 befindet sich der Block bzw. Vorsprung 49 mit dem Loch 50. Im Eckkörper 2, 3, 4, 5 und 21 ist weiterhin ein Loch 77 im Nutboden vorgesehen, in das eine Schneidschraube 78 eingesetzt wird, mit der die Profilträger 7 bzw. 7 a am jeweiligen Eckverbinder befestigt werden.

Von den Innenseiten der Ränder 64 gehen zylinder- oder kegelstumpfförmige Vorsprünge 79 mit Innengewinden aus. Die Eckkörper 2, 3, 4, 5, 21 haben jeweils Löcher 80, in die Schrauben 81 eingesetzt werden, mit denen die Ränder 64 bzw. die Abdeckungen an den Eckkörpern angeschraubt werden.

Von den Eckkörpern 2, 4, 5, 21 gehen weiterhin Nasen 82, 83 aus, die in die Nuten 68, 69 der Profilträger 8 ragen und eine formschlüssige Verbindung zu diesen herstellen.

In den Nasen 82, 83 sind jeweils Löcher 84, 85 vorhanden, in die Schneidschrauben eingesetzt werden, mit denen jeweils die Profilträger 8 an den Eckkörpern 2, 4, 5, 21 und die Winkel 11 an den Eckkörpern 2, 4, 5, 21 befestigt werden.

Durch die schmale Ausbildung der Nuten 35 und 53 und deren geneigten bzw. schrägen Verlauf zu den Wandungen bzw. Flächen 34, 52, von denen erstere ausgehen; tritt bei der Beschichtung der Gehäuseteile kein Lack in die Nuten 35, 53 ein. Beim Lackieren müssen die Nuten 35, 53 daher nicht eigens abgedeckt werden, wodurch sich Einsparungen bei der Herstellung der Teile ergeben.

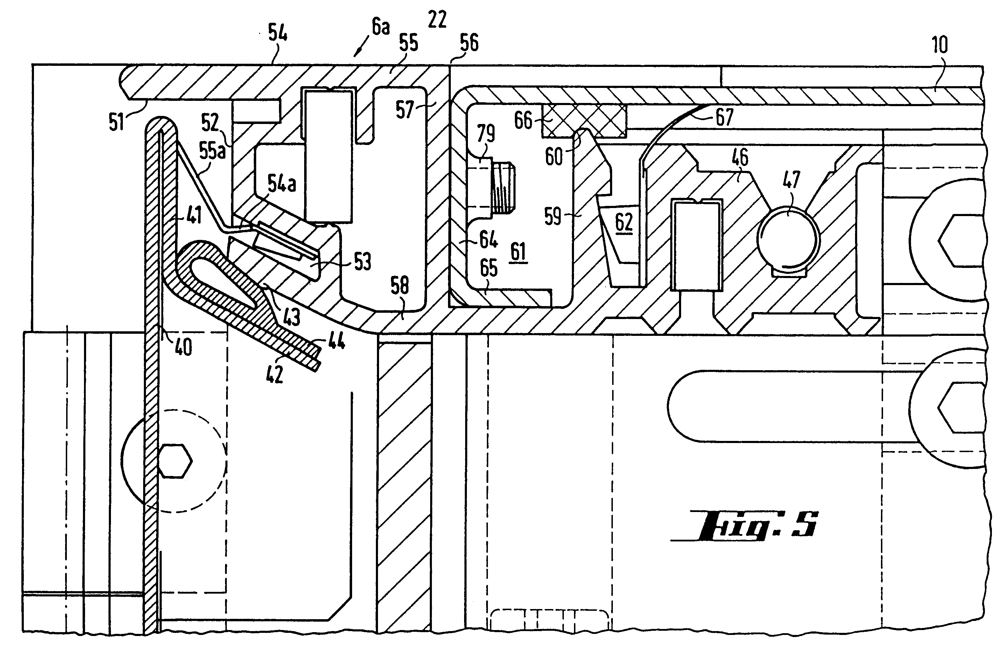

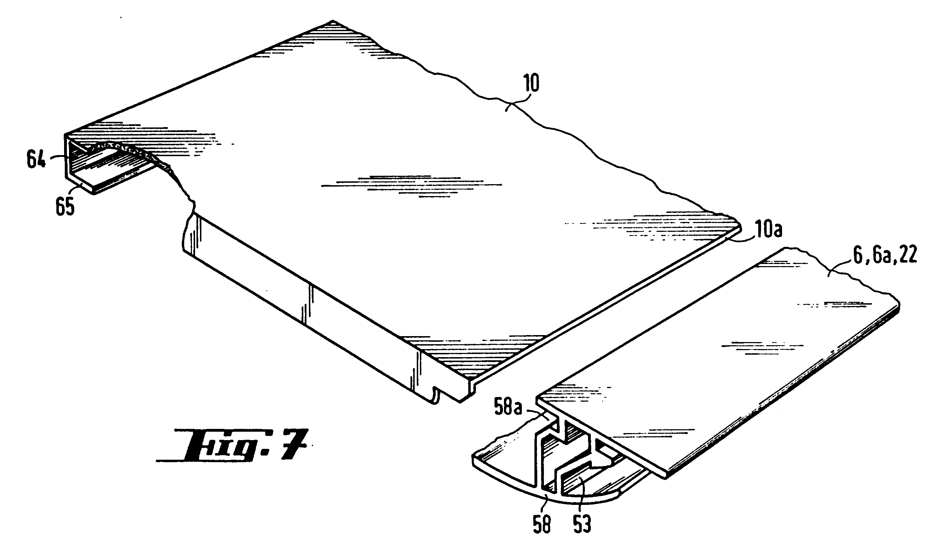

In Fig. 7 ist im Ausschnitt ein Abdeckblech 10 dargestellt, dessen einer Rand U-förmig gekantet ist, wie dies auch in Fig. 5 dargestellt wird. Der Rand weist folglich zur Außenfläche des Abdeckbleches 10 um rechte Winkel abgekantete Schenkel 64 und 65 auf.

Gegenüberliegend ist das Abdeckblech 10 nicht umgebogen und wird in einem Profilträger 6, 6 a oder 22 eingesetzt, und zwar in eine Nut 58 a. Ansonsten weist der Profilträger 6, 6 a bzw. 22 einen prinzipiellen Aufbau auf, wie dieser anhand der Fig. 5 erläutert worden ist.

Dadurch, dass das Abdeckblech 10 in die Nut 58 a mit seinem vorderen Rand 10 a eingesteckt ist, um eine Festlegung und Befestigung sicherzustellen, ist der Vorteil gegeben, dass Abdeckbleche 10 auf eine gewünschte Tiefe abgelenkt werden können, wodurch sich sowohl bei der Herstellung als auch Bevorratung von vorgefertigten Abdeckblechen 10 Vorteile ergeben.

## Patentansprüche

1. Gehäuse aus Metall oder metallisiertem Werkstoff für elektrische Baugruppen und Komponenten mit Gehäusekanten (6, 6 a, 7, 7 a, 8, 22, 23) und Gehäuseecken (2, 3, 4, 5, 21) umfassenden Rahmen und von diesen aufnehmbaren Seitenwänden (9) sowie oberen und unteren Wänden (10),
**dadurch gekennzeichnet**,
dass die Gehäusekanten metallische Profilträger (6, 6 a, 7, 7 a, 8, 22, 23) und die Gehäuseecken metallische Eckkörper (2, 3, 4, 5, 21) sind, dass jeder Eckkörper mit drei Profilträgern verschraubt ist, die sich in drei jeweils rechtwinklig zueinander ausgerichteten Richtungen erstrecken, dass die Seitenwände (9) durch in Nuten (31) zumindest der vorderen und rückwärtigen Profilträger (7, 7 a, 23) eingespannte Platten (9) gebildet sind und dass die oberen und unteren Wände (10) als mit ihren Rändern in Nuten (61) der vorderen und rückwärtigen Profilträger (6, 6 a, 22) und Absätze (74) der seitlichen Profilträger (8) eingesetzte metallische Platten ausgebildet sind.

2. Gehäuse nach Anspruch 1,
**dadurch gekennzeichnet**,
dass die Profilträger (6, 6 a, 22, 7, 7 a, 23) jeweils eine in ihrer Achsrichtung verlaufende Ausnehmung wie Loch (25, 47) aufweisen, das mit einer Ausnehmung wie Loch (77, 50) in dem formschlüssig an den Profilträger (6, 6 a, 23, 7, 7 a, 23) anlegbaren Eckkörper (2, 3, 4, 5, 21) fluchtet und in das ein Verbindungselement wie Schneidschraube (48, 78) einsetzbar ist, mit der der jeweilige Profilkörper am Eckkörper befestigbar ist.

3. Gehäuse nach Anspruch 1 oder 2,
**dadurch gekennzeichnet**,
dass für die Frontseite zwei verschiedene Arten von Profilträgern (6, 22) und Eckkörpern (2, 3, 21) vorgesehen sind.

4. Gehäuse nach Anspruch 3,
**dadurch gekennzeichnet**,
dass bei der einen Art von Profilträgern (6, 7) und Eckkörpern (2, 3) zur Frontseite hin nutenlose, glatte Flächen (13, 15, 17) vorgesehen sind.

5. Gehäuse nach Anspruch 3,
**dadurch gekennzeichnet**,
dass in den Profilträgern (22, 23) und Eckkörper (21), die das Gehäuse vorder- und rückseitig rahmenartig umgeben, an ihrer Vorder- und Rückseite jeweils eine offene, schmale Nut (35, 53) für Blattfedern (36, 54) bzw. elektrisch leitenden Verbindungen zu Front- und Abdeckplatten aufweisen.

6. Gehäuse nach zumindest einem der vorhergehenden Ansprüche,
**dadurch gekennzeichnet**,
dass horizontal verlaufende Profilträger (6, 6 a, 22) und beiderseits mit diesen verbundene Eckkörper (2, 3, 21) nach oben bzw. unten offene, parallele Nuten (61, 62) aufweisen, von denen die näher an den Gehäusemitten angeordneten Nuten (62) mit Anschlagfläche für Blattfedern (67) versehen sind, die mit Endabschnitten unverlierbar in den Nuten gehalten sind und mit Fahnen aus den Nuten als Anschlagflächen an Abdeckungen (10) anliegend herausragen.

7. Gehäuse nach zumindest einem der vorhergehenden Ansprüche,
**dadurch gekennzeichnet**,
dass die obere und untere Abdeckung (10) aus metallischen ebenen Blechen mit an drei Seiten rechtwinklig abgewinkelten Rändern (63, 64) besteht, von denen an einer Seite der Rand zusätzlich eine rechtwinklig abgewinkelte Randzone (65) aufweist.

8. Gehäuse nach zumindest einem der vorhergehenden Ansprüche,
**dadurch gekennzeichnet**,
dass an den Eckkörpern (2, 3, 4, 5, 21) in Richtung der Seitenwände Laschen (82) vorgesehen sind, die in Nuten (69) der die Seitenwände (9) oben und unten begrenzenden Profilträger (8) eingreifen und wenigstens eine Gewindebohrung zum Anschrauben von Winkeln (11) für die Befestigung mit seitlichen Rändern von Baugruppenträgern aufweisen.

9. Gehäuse nach zumindest einem der vorhergehenden Ansprüche,
**dadurch gekennzeichnet**,
dass die Abdeckplatte (10) entlang eines Längsrandes U-förmig abgekantet und auf gegenüberliegender Seite ungekantet in einer Nut (58 a) eines Profilträgers (6, 6 a, 22) einsteckbar ist.
